Europäisches Patentamt

European Patent Office

Office européen des brevets

(11) Veröffentlichungsnummer: **0 246 404 B1**

## EUROPÄISCHE PATENTSCHRIFT

(45) Veröffentlichungstag der Patentschrift: **30.12.92**

(51) Int. Cl.5: **H03M 1/22**, G01D 13/12, G01D 5/245, G01B 7/02

(21) Anmeldenummer: **87103158.9**

(22) Anmeldetag: **05.03.87**

(54) **Messverfahren.**

(30) Priorität: **22.05.86 DE 3617254**

(43) Veröffentlichungstag der Anmeldung:
**25.11.87 Patentblatt 87/48**

(45) Bekanntmachung des Hinweises auf die
Patenterteilung:
**30.12.92 Patentblatt 92/53**

(84) Benannte Vertragsstaaten:
**AT CH DE ES FR GB IT LI**

(56) Entgegenhaltungen:
DE-B- 1 287 630
FR-A- 2 229 949
GB-A- 2 163 253

(73) Patentinhaber: **Dr. Johannes Heidenhain GmbH**
**Dr.-Johannes-Heidenhain-Strasse 5 Postfach 1260**
**W-8225 Traunreut(DE)**

(72) Erfinder: **Reimar, Wolfgang, Dipl.-Ing.**
**Kampenwandstrasse 43**
**W-8225 Traunreut(DE)**
Erfinder: **Oberhans, Johann**
**Post Emertsham**
**W-8221 Buchöster 36(DE)**

**Beschreibung**

Die Erfindung betrifft ein Verfahren gemäß dem Oberbegriff des Anspruchs 1.

Meßeinrichtungen zur Messung der Relativlage zweier Objekte werden insbesondere bei Bearbeitungsmaschinen zur Messung der Relativlage eines Werkzeugs bezüglich eines zu bearbeitenden Werkstücks sowie bei Koordinatenmeßmaschinen zur Ermittlung von Lage und/oder Abmessungen von Prüfobjekten eingesetzt.

Bei einer solchen Meßeinrichtung können die an den Referenzmarken erzeugten Referenzsignale auf verschiedene Weise verwertet werden, z.B. zum Reproduzieren der Nullposition im Zähler, zum Anfahren einer bestimmten Position zu Beginn einer Messung oder zur Kontrolle von Störimpulsen sowie zur Beaufschlagung einer nachgeschalteten Steuereinrichtung.

Aus der DE-AS 25 40 412 ist eine Meßeinrichtung bekannt, bei der eine Maßverkörperung eine Teilung und dieser Teilung absolut zugeordnete identische Referenzmarken in zueinander festgelegten Abständen aufweist. Zur Auswahl wenigstens einer für die Messung benetigten Referenzmarke ist wenigstens ein in einer Nut des Maßstabs verschiebbares Auswahlelement in Form eines Magneten vorgesehen. Eine Abtasteinheit tastet die Teilung zur Erzeugung wenigstens eines periodischen Abtastsignals und die Referenzmarken zur Erzeugung von Referenzsignalen ab. Die Abtasteinheit enthält ferner ein Schaltelement, das beim Überfahren eines einer ausgewählten Referenzmarke zugeordneten Auswahlelements ein Auswahlsignal liefert. Nur beim gleichzeitigen Auftreten des Referenzsignals der ausgewählten Referenzmarke und des zugeordneten Auswahlsignals gibt eine nachgeschaltete Baueinheit ein Steuersignal ab.

Beim Einsatz dieser Meßeinrichtung an einer Bearbeitungsmaschine kann es aber bei Erschütterungen zu Verschiebungen des Auswahlelements in der Nut kommen, so daß die eindeutige Zuordnung des Auswahlelements zur ausgewählten Referenzmarke und ein Wirksamwerden der ausgewählten Referenzmarke nicht mehr gewährleistet sind. Bei dicht benachbarten Referenzmarken kann bei derartigen Verschiebungen des Auswahlelements auch eine falsche Referenzmarke zur Wirkung gelangen, so daß ein falscher Steuervorgang, beispielsweise ein Nullungsvorgang, im Zähler ausgelöst wird, der ein falsches Meßergebnis zur Folge hat. Jedes in Bewegungsrichtung der Abtasteinheit verschiebbare Auswahlelement muß daher bezüglich der jeweils ausgewählten Referenzmarke in einer reproduzierbaren Lage mittels zusätzlicher Mittel in der Nut fixierbar sein.

In der DE-PS 32 45 914 ist eine Meßeinrichtung beschrieben, bei der eine Maßverkörperung eine Teilung und dieser Teilung absolut zugeordnete identische Referenzmarken in zueinander festgelegten Abständen aufweist. Zur Auswahl wenigstens einer für die Messung benötigten Referenzmarke ist den Referenzmarken eine Spur mit wenigstens einer elektrisch aufgebrachten Auswahlinformation zugeordnet, die von einem Element der Abtasteinheit abgetastet wird, so daß wenigstens eine Referenzmarke ausgewählt und zur Wirkung gebracht werden kann.

Bei dieser Meßeinrichtung ist zwar eine unveränderliche eindeutige Zuordnung der Auswahlinformation zur ausgewählten Referenzmarke gewährleistet, jedoch sind zur Auswahl der für die Messung benötigten Referenzmarken eine gesonderte Spur mit den zugehörigen Auswahlinformationen auf der Maßverkörperung sowie ein zusätzliches Element in der Abtasteinheit zur Abtastung dieser Auswahlinformation erforderlich.

In der DE-PS 29 52 106 ist eine Meßeinrichtung angegeben, bei der eine Maßverkörperung eine Teilung und dieser Teilung absolut zugeordnete Referenzmarken mit jeweils unterschiedlichen Strichgruppenverteilungen aufweist. Zur Auswahl der einzelnen für die Messung benötigten Referenzmarken ist in der Abtasteinheit jeder Referenzmarke jeweils ein Abtastfeld mit einer identischen Strichgruppenverteilung zugeordnet. Diese Anordnung ist relativ aufwendig, da die Strichgruppenverteilungen der einzelnen Referenzmarken und der jeweils zugehörigen Abtastfelder sich möglichst stark voneinander unterscheiden müssen, um eine eindeutige Identifizierung der einzelnen Referenzmarken zu ermöglichen. Die Abtasteinrichtung muß dabei für jede Referenzmarke ein identisches Abtastfeld aufweisen.

Der DE-OS 30 39 483 (EP-A-0 050 195 bzw. US-A-4,491, 928) entnimmt man eine Meßeinrichtung, bei der eine Maßverkörperung eine Teilung und dieser Teilung absolut zugeordnete identische Referenzmarken in gleichen Abständen aufweist, Zur Identifizierung der einzelnen identischen Referenzmarken ist jeder Referenzmarke eine Codemarke zugeordnet. Zur Abtastung dieser Codemarken sind aber gesonderte Abtastfelder auf der Abtastplatte der Abtasteinheit erforderlich. Nach der Abtastung der gesamten Codeinformation jeder Codemarke kann die zugehörige Referenzmarke mit ihrem zugehörigen Absolutwert identifiziert werden.

Die EP-A-0 172 323 beschreibt eine Meßeinrichtung, bei der eine Maßverkörperung eine Teilung und dieser Teilung absolut zugeordnete identische Referenzmarken aufweist. Zur Identifizierung der einzelnen identischen Referenzmarken ist jeder Referenzmarke eine Codemarke zugeordnet, die aus mehreren Codemarkenteilen besteht. Jeder Codemarkenteil kann eine von zwei Positionen gemäß der gewünschten Codeinformation einnehmen. Die Erkennung der jeweiligen Position jedes Codemarkenteils erfolgt mittels zweier Abstände zwischen den Codemarkenteilen, die durch Abtastung der Teilung gewonnen werden. Nach der Ermittlung der gesamten Codeinformation jeder Codemarke kann die zugehörige Referenzmarke mit ihrem Absolutwert identifiziert werden.

Aus der DE-PS 24 16 212 ist eine Meßeinrichtung bekannt, bei der eine Maßverkörperung eine Teilung und dieser Teilung absolut zugeordnete identische Referenzmarken aufweist. Der Absolutwert jeder Referenzmarke bestimmt sich aus ihrem jeweiligen spezifischen Abstand zu einer benachbarten Referenzmarke; diese unterschiedlichen Abstände zwischen den benachbarten Referenzmarken werden durch die Abtastung der inkrementalen Teilung ermittelt. Zur Identifizierung jeder einzelnen identischen Referenzmarke müssen diese Referenzmarke und die zugehörige benachbarte Referenzmarke abgetastet und deren gegenseitiger spezifischer Abstand ermittelt werden.

Je größer jedoch bei dieser Meßeinrichtung die Meßlänge und damit die Anzahl der vorgesehenen identischen Referenzmarken sind, desto mehr unterschiedliche Abstände werden benötigt. Dadurch liegen die Referenzmarken mit den größten zugeordneten Abständen so weit auseinander, daß zur Identifizierung und Bestimmung der Absolutwerte solcher Referenzmarken bei der Abtastung dieser Referenzmarken und der benachbarten Referenzmarken diesen größten Abständen entsprechende Teilungslängen der inkrementalen Teilung zurückgelegt werden müssen, so daß die Identifizierung dieser Referenzmarken mit großen zugeordneten Abständen umständlich und zeitraubend ist und keinen wirtschaftlichen Einsatz einer derartigen Meßeinrichtung beispielsweise bei einer Bearbeitungsmaschine erlaubt. Wenn während eines Bearbeitungsablaufes an einer Bearbeitungsmaschine beispielsweise durch einen Stromausfall der momentane Positionsmeßwert verloren geht, muß nach der Behebung der Störung für die weiteren Meßvorgänge vorab eine absolute Bezugsposition der Meßeinrichtung wiedergewonnen werden; diese Wiedergewinnung der absoluten Bezugsposition der Meßeinrichtung wird aus Zeitgründen mittels der nächstgelegenen Referenzmarke vorgenommen werden. Zur Identifizierung dieser nächstgelegenen Referenzmarke und damit zur Ermittlung ihres Absolutwertes für die Wiedergewinnung der absoluten Bezugsposition müssen diese Referenzmarke und ihre zugehörige benachbarte Referenzmarke abgetastet und ihr gegenseitiger spezifischer Abstand durch Abtastung der inkrementalen Teilung ermittelt werden. Wenn dieser spezifische Abstand sehr groß ist, ist die Identifizierung der betreffenden Referenzmarke entsprechend zeitraubend und trägt zur Vergrößerung der Fehlzeiten der Bearbeitungsmaschine bei. Hinzu kommt, daß bisweilen die Abtastung derartiger großer Abstände durch die vorliegende Werkstückgeometrie nicht möglich ist.

Der Erfindung liegt die Aufgabe zugrunde, bei einer Meßeinrichtung der genannten Gattung den Zeitaufwand für die Identifizierung und für die Bestimmung der Absolutwerte der einzelnen Referenzmarken zu verringern und die Anzahl der Referenzmarken pro Meßlängeneinheit zu erhöhen.

Diese Aufgabe wird erfindungsgemäß durch die Merkmale des Anspruches 1 gelöst.

Die mit der Erfindung erzielten Vorteile bestehen insbesondere darin, daß durch die vorgeschlagene Ermittlung von wenigstens zwei aufeinanderfolgenden Abständen zur Bestimmung des Absolutwertes jeder Referenzmarke ohne zusätzlichen Aufwand und ohne zusätzliche Elemente eine dichtere Folge von Referenzmarken auf der Maßverkörperung erzielt wird, so daß die Kontrolle des Zählerstandes des Zählers der meßeinrichtung bzw. die Korrektur dieses Zählerstandes in kürzeren Abständen erfolgen kann. Da durch die Kombination vorzugsweise zweier Abstände diese Abstände mehrfach vorkommen können, ist die Gesamtlänge dieser beiden Abstände geringer als der bekannte Einzelabstand, da diese Einzelabstände sich generell voneinander unterscheiden müssen. Es ergibt sich somit ein erheblicher Raumgewinn zum Vorsehen zusätzlicher Referenzmarken auf der Maßverkörperung und im Störfall ein verringerter Zeitaufwand zur Bestimmung des Absolutwertes der nächstgelegenen Referenzmarke nach Beseitigung der Störung zur Wiedergewinnung einer Bezugsposition.

Vorteilhafte Ausbildungen der Erfindung entnimmt man den abhängigen Ansprüchen.

Ein Ausführungsbeispiel der Erfindung wird anhand der Zeichnung näher erläutert.

Es zeigen

Figur 1    eine lichtelektrische inkrementale Längenmeßeinrichtung in einer schematischen Seitenansicht;

Figur 2    eine Maßverkörperung mit Referenzmarken und

Figur 3    eine Maßverkörperung mit Referenzmarken, eine Abtastplatte und eine Photoelementenplatte.

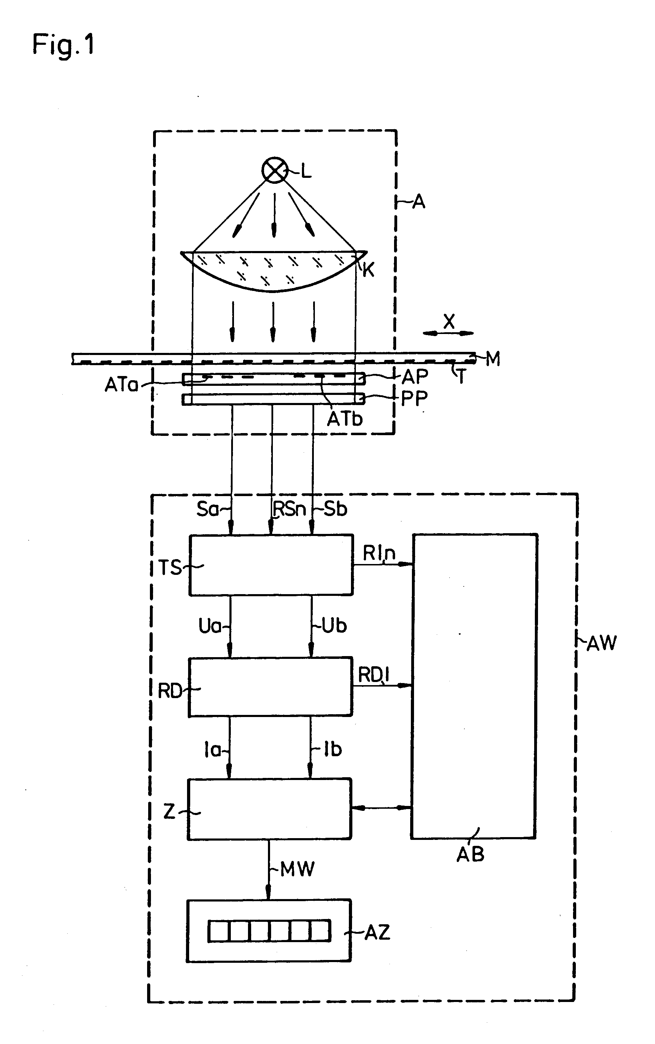

In Figur 1 ist eine lichtelektrische inkrementale Längenmeßeinrichtung in einer schematischen Seitenansicht dargestellt, die aus einer Maßverkörperung M in Form eines Maßstabes und aus einer Abtasteinheit A besteht, die in nicht gezeigter Weise jeweils mit Objekten verbunden sind, deren Relativlage gemessen werden soll; diese beiden Objekte können beispielsweise durch das Bett und durch einen Schlitten einer Bearbeitungsmaschine gebildet sein. Auf dem Maßstab M ist eine inkrementale Teilung T aufgebracht, die im Durchlicht berührungsfrei lichtelektrisch von der Abtasteinheit A abgetastet wird. Die Abtasteinheit A enthält eine Lichtquelle L, einen Kondensor K, eine Abtastplatte AP sowie eine Photoelementenplatte PP.

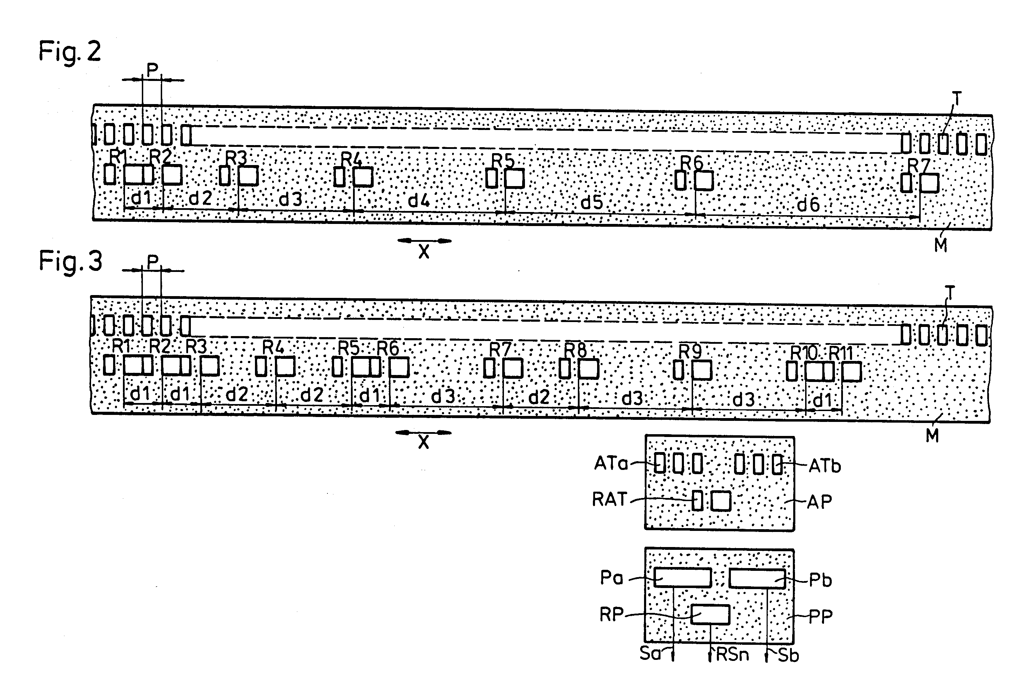

In Figur 3 sind der Maßstab M, die Abtastplatte AP sowie die Photoelementenplatte PP in einer Draufsicht dargestellt. Der Maßstab M weist die inkrementale Teilung T mit einer Periodenlänge P in Form eines äquidistanten Strichgitters und entlang dieser Teilung T in Meßrichtung X identische Referenzmarken Rn (n = 1,2,3,...) mit einer bestimmten unregelmäßigen Strichverteilung auf, die der inkrementalen Teilung T absolut zugeordnet sind; diese Referenzmarken Rn weisen in Meßrichtung X bestimmte gegenseitige Abstände dn (n = 1,2,3,...) auf, die nachfolgend noch näher erläutert werden. Zur Abtastung der Teilung T enthält die Abtastplatte AP zwei Abtastteilungen ATa, ATb, die die gleiche Periodenlänge P wie die Teilung T aufweisen und mit dieser identisch sind, aber in Meßrichtung X um ein Viertel der Periodenlänge P gegeneinander versetzt sind. Zur Abtastung der Teilung T sind ferner auf der Photoelementenplatte PP zwei Photoelemente Pa, Pb angeordnet, die den beiden Abtastteilungen ATa, ATb der Abtastplatte AP jeweils zugeordnet sind.

Bei der Meßbewegung der Abtasteinheit A bezüglich des Maßstabs M in Meßrichtung X werden die von der Lichtquelle L ausgehenden, vom Kondensor K parallel gerichteten Lichtstrahlen durch die Teilung T und die beiden Abtastteilungen ATa, ATb moduliert und fallen auf die beiden Photoelemente Pa, Pb, die zwei periodische Abtastsignale Sa, Sb erzeugen, die einer Triggerstufe TS in einer Auswerteeinrichtung AW zur Triggerung zugeleitet werden (Figur 1). Die Triggerstufe TS erzeugt aus den beiden Abtastsignalen Sa, Sb zwei Rechtecksignale Ua, Ub, die in der Auswerteeinrichtung AW über einen Richtungsdiskriminator RD einem Vorwärts-/Rückwärtszähler Z zum vorzeichenrichtigen Zählen der vom Richtungsdiskriminator RD erzeugten Impulse Ia, Ib zugeführt werden; die vom Vorwärts-Rückwärtszähler Z vorzeichengerecht gezählten Teilungseinheiten mit der Periodenlänge P der inkrementalen Teilung T des Maßstabs M werden als Meßwerte MW für die jeweilige Relativlage der beiden Objekte einer Anzeigeeinheit AZ zur digitalen Anzeige dieser Positionsmeßwerte MW zugeleitet. Die Diskriminierung der Meßrichtung X im Richtungsdiskriminator RD erfolgt aufgrund des 90°-Phasenversatzes der beiden Rechtecksignale Ua, Ub infolge des gegenseitigen Phasenversatzes der beiden Abtastteilungen ATa, ATb um ein Viertel der Periodenlänge P.

Zur Abtastung der einzelnen identischen Referenzmarken Rn des Maßstabs M enthält die Abtastplatte AP eine Referenzabtastteilung RAT, die in ihrer Strichverteilung mit der Strichverteilung der Referenzmarken Rn identisch ist. Zur Abtastung der einzelnen identischen Referenzmarken Rn ist ferner auf der Photoelementenplatte PP ein Referenzphotoelement RP als Referenzabtastelement vorgesehen, das der Referenzabtastteilung RAT der Abtastplatte AP zugeordnet ist.

Gemäß Figur 2 weist ein bekannter Maßstab M eine inkrementale Teilung T mit einer Periodenlänge P und entlang dieser Teilung T in Meßrichtung X identische Referenzmarken Rn mit einer bestimmten unregelmäßigen Strichverteilung auf, die der inkrementalen Teilung T absolut zugeordnet sind; bezüglich dieser Elemente besteht Übereinstimmung zwischen den beiden Maßstäben M der Figuren 2 und 3.

In Figur 2 bestehen von links nach rechts zwischen der ersten Referenzmarke R1 und der zweiten Referenzmarke R2 ein erster Abstand d1, zwischen der zweiten Referenzmarke R2 und der dritten Referenzmarke R3 ein zweiter Abstand d2, zwischen der dritten Referenzmarke R3 und der vierten Referenzmarke R4 ein dritter Abstand d3 usw; dabei bezeichnen die Ziffer 1 des Abstands d1 die Abstandseinheit und die Ziffern 2,3,... der Abstände d2, d3,... ganzzahlige Vielfache dieser Abstandseinheit, die im Ausführungsbeispiel zwei Teilungseinheiten mit der jeweiligen Periodenlänge P der inkrementalen Teilung T beträgt. Diese Abstände dn (n = 1,2,3,...) der Referenzmarken Rn zu den benachbarten Referenzmarken Rn + 1 kennzeichnen die Absolutwerte dieser identischen Referenzmarken Rn, Rn + 1 bezüglich der inkrementalen Teilung T und erstrecken sich zwischen den Mitten (Bezugszentren) dieser Referenzmarken Rn, Rn + 1.

Bei der Meßbewegung der Abtasteinheit A bezüglich des Maßstabs M der Figur 2 in Meßrichtung X von links nach rechts erzeugt bei der Abtastung der Referenzmarken R1, R2, R3,... mittels der Referenzabtastteilung RAT der Abtastplatte AP und des Referenzphotoelements RP der Photoelementenplatte PP gemäß Figur 3 das Photoelement RP den identischen Referenzmarken Rn zugehörige identische Referenzsignale RSn, die ununterscheidbar sind; diese Referenzsignale RSn werden der Triggerstufe TS zur Erzeugung von Referenzimpulsen RIn zugeführt, die eine Absolutwertbestimmungseinrichtung AB beaufschlagen. Eine derartige bekannte Absolutwertbestimmungseinrichtung AB ist beispielsweise in der DE-PS 24 16 212 beschrieben und enthält einen Zählerstandspeicher, einen Zählerstandvergleicher, eine Zuordnungsvorrichtung und logische Verknüpfungselemente.

Beispielsweise zur Bestimmung des Absolutwertes der zweiten Referenzmarke R2 werden von links nach rechts in positiver Meßrichtung X die erste Referenzmarke R1 und anschließend die zweite Referenzmarke R2 abgetastet. Der bei der Abtastung der ersten Referenzmarke R1 erzeugte erste Referenzimpuls RI1 speichert zu diesem ersten Zeitpunkt den Zählerstand des Vorwärts-/Rückwärtszählers Z im Zähler-

<div align="center">4</div>

standspeicher der Absolutwertbestimmungseinrichtung AB. Der bei der Abtastung der zweiten Referenzmarke R2 erzeugte zweite Referenzimpuls RI2 veranlaßt zu diesem zweiten Zeitpunkt den Zählerstandvergleicher zur Ermittlung der Differenz zwischen dem momentanen Zählerstand des Vorwärts-/Rückwärtszählers Z und dem Zählerstand des Zählerstandspeichers. Diese Differenz zwischen den beiden Zählerständen stellt den ersten Abstand d1 zwischen der ersten Referenzmarke R1 und der zweiten Referenzmarke R2 dar; dieser erste Abstand d1 des Zählerstandvergleichers wird der Zuordnungsvorrichtung zur Ausgabe des zugehörigen Absolutwertes der zweiten Referenzmarke R2 an den Vorwärts-/Rückwärtszähler Z zur Kontrolle seines Zählerstandes bzw. zur Korrektur seines Zählerstandes bei einem fehlerhaften Zählerstand zugeleitet.

Zur Bestimmung des Absolutwertes der zweiten Referenzmarke R2 von rechts nach links in negativer Meßrichtung X werden die dritte Referenzmarke R3 und anschließend die zweite Referenzmarke R2 abgetastet. Der auf die gleiche oben beschriebene Weise mittels des dritten Referenzimpulses RI3 und des zweiten Referenzimpulses RI2 ermittelte zweite Abstand d2 des Zählerstandvergleichers wird der Zuordnungsvorrichtung zur Ausgabe des zugehörigen Absolutwertes der zweiten Referenzmarke R2 an den Vorwärts-/Rückwärtszähler Z ebenfalls zur Kontrolle seines Zählerstandes bzw. zur Korrektur seines Zählerstandes bei einem fehlerhaften Zählerstand zugeleitet.

Die den jeweiligen identischen Referenzmarken Rn zugehörigen Absolutwerte sind in Abhängigkeit von den zugeordneten spezifischen Abständen dn-1, dn je nach der vorliegenden positiven oder negativen Meßrichtung X in der Zuordnungsvorrichtung in Tabellenform abgespeichert, wobei für die positive Meßrichtung X eine gesonderte Tabelle für die Abstände dn-1 und für die negative Meßrichtung X eine gesonderte Tabelle für die Abstände dn vorgesehen sind; die jeweils vorliegende positive oder negative Meßrichtung X wird der Absolutwertbestimmungseinrichtung AB durch einen Richtungsimpuls RDI des Richtungsdiskriminators RD übermittelt. Mit dieser Bestimmung des Absolutwertes einer Referenzmarke Rn kann ferner eine durch eine Störung verlorengegangene Bezugsposition nach der Beseitigung dieser Störung durch die Bestimmung des Absolutwertes der nächstgelegenen Referenzmarke Rn wiedergewonnen werden.

Je größer jedoch die Meßlänge dieses bekannten Maßstabes M und damit die Anzahl der vorgesehenen identischen Referenzmarken Rn sind, desto mehr unterschiedliche Abstände dn werden benötigt. Dadurch liegen die Referenzmarken Rn mit den größten zugeordneten Abständen dn so weit auseinander, daß zur Identifizierung und Bestimmung der Absolutwerte solcher Referenzmarken Rn bei der Abtastung dieser Referenzmarken Rn und der benachbarten Referenzmarken Rn + 1 diesen größten Abständen dn entsprechende Teilungslängen der inkrementalen Teilung T zurückgelegt werden müssen.

Zur Verringerung des Zeitaufwandes bei der Identifizierung und bei der Bestimmung der Absolutwerte dieser Referenzmarken Rn und zur Vergrößerung der Anzahl der Referenzmarken Rn pro Meßlängeneinheit wird vorgeschlagen, zur Bestimmung des Absolutwertes jeder Referenzmarke Rn wenigstens zwei aufeinanderfolgende Abstände dn-2, dn-1; dn-1, dn; dn, dn + 1 zwischen dieser Referenzmarke Rn und wenigstens zwei benachbarten Referenzmarken Rn-2, Rn-1; Rn-1, Rn + 1; Rn + 1, Rn + 2 zu ermitteln.

Beispielsweise zur Bestimmung des Absolutwertes der dritten Referenzmarke R3 gemäß Figur 3 werden von links nach rechts in positiver Meßrichtung X die erste Referenzmarke R1 und anschließend die zweite Referenzmarke R2 abgetastet. Der bei der Abtastung der ersten Referenzmarke R1 erzeugte erste Referenzimpuls RI1 speichert zu diesem ersten Zeitpunkt den Zählerstand des Vorwärts-/Rückwärtszählers Z im Zählerstandspeicher der Absolutwertbestimmungseinrichtung AB. Der bei der Abtastung der zweiten Referenzmarke R2 erzeugte zweite Referenzimpuls RI2 veranlaßt zu diesem zweiten Zeitpunkt den Zählerstandvergleicher zur Ermittlung der Differenz zwischen dem momentanen Zählerstand des Vorwärts-/Rückwärtszählers Z und dem Zählerstand des Zählerstandspeichers. Diese Differenz zwischen den beiden Zählerständen stellt den ersten Abstand d1 zwischen der ersten Referenzmarke R1 und der zweiten Referenzmarke R2 dar; dieser erste Abstand d1 des Zählerstandvergleichers wird der Zuordnungsvorrichtung zugeleitet und der momentane Zählerstand des Vorwärts-/Rückwärtszählers Z zu diesem zweiten Zeitpunkt in den Zählerstandspeicher eingespeichert.

Der bei der nachfolgenden Abtastung der dritten Referenzmarke R3 erzeugte dritte Referenzimpuls RI3 veranlaßt zu diesem dritten Zeitpunkt den Zählerstandsvergleicher zur Ermittlung der Differenz zwischen dem momentanen Zählerstand des Vorwärts-/Rückwärtszählers Z und dem Zählerstand des Zählerstandspeichers. Diese Differenz zwischen den beiden Zählerständen stellt den zweiten Abstand d1 zwischen der zweiten Referenzmarke R2 und der dritten Referenzmarke R3 dar; dieser zweite Abstand d1 des Zählerstandvergleichers wird ebenfalls der Zuordnungsvorrichtung zugeleitet. Beim Vorliegen des ersten Abstandes d1 und des zweiten Abstandes d1 gibt die Zuordnungsvorrichtung den zugehörigen Absolutwert der dritten Referenzmarke R3 an den Vorwärts-/Rückwärtszähler Z zur Kontrolle seines Zählerstandes bzw. zur Korrektur seines Zählerstandes bei einem fehlerhaften Zählerstand aus.

Zur Bestimmung des Absolutwertes der dritten Referenzmarke R3 von rechts nach links in negativer Meßrichtung X werden die fünfte Referenzmarke R5 und anschließend die vierte Referenzmarke R4 abgetastet. Der bei der Abtastung der fünften Referenzmarke R5 erzeugte fünfte Referenzimpuls RI5 speichert zu diesem ersten Zeitpunkt den Zählerstand des Vorwärts-/Rückwärtszählers Z im Zählerstandspeicher der Absolutwertbestimmungseinrichtung AB. Der bei der Abtastung der vierten Referenzmarke R4 erzeugte vierte Referenzimpuls RI4 veranlaßt zu diesem zweiten Zeitpunkt den Zählerstandvergleicher zur Ermittlung des Differenzbetrages zwischen dem momentanen Zählerstand des Vorwärts-/Rückwärtszählers Z und dem Zählerstand des Zählerstandspeichers. Dieser Differenzbetrag zwischen den beiden Zählerständen stellt den ersten Abstand d2 zwischen der fünften Referenzmarke R5 und der vierten Referenzmarke R4 dar; dieser erste Abstand d2 des Zählerstandvergleichers werden der Zuordnungsvorrichtung zugeleitet und der momentane Zählerstand des Vorwärts-/Rückwärtszählers Z zu diesem zweiten Zeitpunkt in den Zählerstandspeicher eingespeichert. Der bei der nachfolgenden Abtastung der dritten Referenzmarke R3 erzeugte dritte Referenzimpuls RI3 veranlaßt zu diesem dritten Zeitpunkt den Zählerstandvergleicher zur Ermittlung des Differenzbetrages zwischen dem momentanen Zählerstand des Vorwärts-/Rückwärtszählers Z und dem Zählerstand des Zählerstandspeichers. Dieser Differenzbetrag zwischen den beiden Zählerständen stellt den zweiten Abstand d2 zwischen der vierten Referenzmarke R4 und der dritten Referenzmarke R3 dar; dieser zweite Atstand d2 des Zählerstandvergleichers wird ebenfalls der Zuordnungsvorrichtung zugeleitet. Beim Vorliegen des ersten Abstandes d2 und des zweiten Abstandes d2 gibt die Zuordnungsvorrichtung den zugehörigen Absolutwert der dritten Referenzmarke R3 an den Vorwärts-/Rückwärtszähler Z zur Kontrolle seines Zählerstandes bzw. zur Korrektur seines Zählerstandes bei einem fehlerhaften Zählerstand aus.

In den Figuren 2 und 3 erstrecken sich die Abstände dn zwischen den Mitten (Bezugszentren) der Referenzmarken Rn, Rn + 1; diese Bezugszentren markieren die Absolutlage der Referenzmarken Rn zur inkrementalen Teilung T. Der Abstand dn beträgt n Abstandseinheiten und die Abstandseinheit zwei Teilungseinheiten mit der jeweiligen Periodenlänge P der inkrementalen Teilung T.

In Figur 2 weist der bekannte Maßstab M sieben Referenzmarken R1-R7 und sechs gegenseitige spezifische Abstände d1-d6 auf, die sich voneinander unterscheiden müssen. In Figur 3 weist der Maßstab M elf Referenzmarken R1-R11 und zehn gegenseitige Abstände d1-d3 auf. Da für die elf Referenzmarken R1-R11 nur drei unterschiedliche Abstände d1-d3 benötigt werden, haben diese elf Referenzmarken R1- R11 gemäß Figur 3 einen geringeren Raumbedarf als die sieben Referenzmarken R1-R7 nach Figur 2.

Wie vorgehend beschrieben, sind zur Identifizierung und Bestimmung der Absolutposition einer Referenzmarke Rn vorzugsweise zwei aufeinanderfolgende Abstände dn-2, dn-1; dn-1, dn; dn, dn + 1 herangezogen worden; es können zu diesem Zweck jedoch auch mehr als zwei Abstände gewählt werden. Wie aus Figur 3 ersichtlich, weisen die unterschiedlichen Kombinationen von zwei Abständen gleiche Abstände oder ungleiche Abstände auf. In der positiven Meßrichtung X und in der negativen Meßrichtung X können identische Kombinationen von zwei Abständen auftreten, die anhand der jeweiligen Meßrichtung X unterscheidbar sind.

In Figur 3 sind von links nach rechts unterschiedliche Kombinationen der kleinstmöglichen Abstände dn dargestellt, um möglichst viele Referenzmarken Rn pro Meßlängeneinheit vorsehen zu können. In der folgenden Tabelle sind in der ersten Zeile die Ziffern n der Abstände dn nach Figur 2 und in der zweiten Zeile die Ziffern n der Abstände dn nach Figur 3 aufgeführt; die Ziffer n bedeutet n Abstandseinheiten, wobei die Abstandseinheit zwei Teilungseinheiten mit der jeweiligen Periodenlänge P der inkrementalen Teilung T beträgt.

| 1 | 2 | 3 | 4 | 5 | 6 | 7 | 8 | 9 | 10 | 11 | 12 | 13 | 14 | 15 | 16 | 17 | S = 153 |
|---|---|---|---|---|---|---|---|---|----|----|----|----|----|----|----|----|---------|
| 1 | 1 | 2 | 2 | 1 | 3 | 2 | 3 | 3 | 1  | 4  | 2  | 4  | 3  | 4  | 4  | 1  | S = 41  |

Wie aus der Tabelle ersichtlich, werden beim bekannten Maßstab M der Figur 2 zur Unterbringung von 18 Referenzmarken eine Strecke S von 153 Abstandseinheiten und beim vorgeschlagenen Maßstab M nach Figur 3 zur Unterbringung von ebenfalls 18 Referenzmarken nur eine Strecke S von 41 Abstandseinheiten benötigt.

Anhand des ermittelten Absolutwertes einer Referenzmarke kann mittels der beiden Abstände auf die Absolutwerte der in Meßrichtung vorangehenden Referenzmarken geschlossen werden.

Im obigen Ausführungsbeispiel sind in bevorzugter Weise identische Referenzmarken vorgesehen; die Erfindung ist aber auch bei Meßeinrichtungen mit Erfolg einsetzbar, die unterschiedliche Referenzmarken aufweisen.

In nicht dargestellter Weise können die Referenzmarken Rn auch auf wenigstens zwei parallel angeordneten Referenzmarkenspuren vorgesehen sein; dadurch können die Referenzmarken Rn sehr dicht aufeinander folgen. Die Referenzmarken Rn jeder Spur werden von einem zugeordneten Referenzabtastelement abgetastet und die gewonnenen Referenzsignale in der Auswerteeinrichtung in geeigneter Weise ausgewertet.

## Patentansprüche

1. Verfahren zur Bestimmung der Absolutwerte von Referenzmarken einer Meßeinrichtung zur Messung der Relativlage zweier Objekte, bei der eine Maßverkörperung (M) eine Teilung (T) und entlang der Teilung (T) in Meßrichtung X dieser Teilung (T) absolut zugeordnete Referenzmarken (Rn) aufweist, bei dem eine Abtasteinheit (A) die Teilung (T) zur Erzeugung wenigstens eines Abtastsignals (Sa, Sb) und die Referenzmarken (Rn) zur Erzeugung von Referenzsignalen (RSn) abtastet und bei dem die Absolutwerte der Referenzmarken (Rn) durch Abtastung der Teilung (T) zur Ermittlung des Abstandes (dn) zwischen Referenzmarken (Rn) bestimmt werden, dadurch gekennzeichnet, daß man die genannten Abstände (dn) so zuordnet, daß zur Bestimmung des Absolutwertes jeder Referenzmarke (Rn) (n = 1, 2, 3, ...) wenigstens zwei Abstände (dn-2, dn-1; dn-1, dn; dn, dn + 1) zwischen dieser Referenzmarke (Rn) und wenigstens zwei weiteren Referenzmarken (Rn-2, Rn-1; Rn-1, Rn + 1; Rn + 1, Rn + 2) von der Abtasteinheit (A) abzutasten sind.

2. Verfahren nach Anspruch 1, dadurch gekennzeichnet, daß identische Kombinationen wenigstens zweier aufeinanderfolgender Abstände (dn-2, dn-1; dn-1, dn; dn, dn + 1) in positiver Meßrichtung X und in negativer Meßrichtung X durch die jeweils vorliegende Meßrichtung X unterschieden werden.

3. Verfahren nach Anspruch 1, dadurch gekennzeichnet, daß die Kombinationen wenigstens zweier aufeinanderfolgender Abstände (dn-2, dn-1; dn-1, dn; dn, dn + 1) in der jeweiligen Meßrichtung X unterschiedlich ausgebildet werden.

4. Verfahren nach Anspruch 1, dadurch gekennzeichnet, daß die Abstände (dn) als ganzzahlige Vielfache der Teilungseinheit mit der Periodenlänge (P) der inkrementalen Teilung (T) ausgebildet werden.

5. Verfahren nach Anspruch 1, dadurch gekennzeichnet, daß die Referenzmarken (Rn) auf wenigstens zwei parallelen Spuren angeordnet werden.

6. Verfahren nach Anspruch 1, dadurch gekennzeichnet, daß die wenigstens zwei Abstände (dn-2, dn-1; dn-1, dn; dn, dn + 1) in einer Absolutwertbestimmungseinrichtung (AB) mittels eines Zählerstandspeichers und eines Zählerstandvergleichers ermittelt und anschließend einer Zuordnungsvorrichtung zugeführt werden, in die zur Bestimmung des Absolutwertes jeder Referenzmarke (Rn) die vorgegebenen wenigstens zwei Abstände (dn-2, dn-1; dn-1, dn; dn, dn + 1) als Abstandstabelle vorab eingespeichert werden.

## Claims

1. A method of determining the absolute value of reference marks of a measuring device for measuring the relative position of two objects, in which a measuring unit (M) has a graduation (T) and reference marks (Rn) associated absolutely with this graduation (T) along the graduation (T) in the measuring direction X, in which a sensing unit (A) senses the graduation (T) and the reference marks (Rn) to generate at least one sensing signal (Sa, Sb) and reference signals (RSn) respectively, and in which the absolute values of the reference marks (Rn) are determined by sensing the graduation (T) to determine the interval (dn) between reference marks (Rn), characterized in that the said intervals (dn) are so arranged that, to determine the absolute value of each reference mark (Rn) (n = 1, 2, 3, ...) at least two intervals (dn-2, dn-1; dn-1, dn; dn, dn + 1) between this reference mark (Rn) and at least two further reference marks (Rn-2, Rn-1; Rn-1, Rn + 1; Rn + 1, Rn + 2) are to be sensed by the sensing unit (A).

2. A method according to claim 1, characterized in that identical combinations of at least two sequential intervals (dn-2, dn-1; dn-1, dn; dn, dn + 1) in the positive measuring direction X and in the negative measuring direction X are distinguished by the measuring direction X currently obtaining.

**3.** A method according to claim 1, characterized in that the combinations of at least two sequential intervals (dn-2, dn-1; dn-1, dn; dn, dn + 1) are formed differently in the respective measuring direction X.

**4.** A method according to claim 1, characterized in that the intervals (dn) are formed as integral multiples of the graduation unit with the periodic length (P) of the incremental graduation (T).

**5.** A method according to claim 1, characterized in that the reference marks (Rn) are arranged on at least two parallel tracks.

**6.** A method according to claim 1, characterized in that the at least two intervals (dn-2, dn-1; dn-1, dn; dn, dn + 1) are determined in a device (AB) determining absolute values by means of a counter state store and a counter state comparator and then are applied to a coordinating device, in which the predetermined at least two intervals (dn-2, dn-1; dn-1, dn; dn, dn + 1) for determining the absolute value of each reference mark (Rn) have been previously stored as a table of intervals.

**Revendications**

**1.** Procédé de détermination de la valeur absolue de repères de référence d'un dispositif de mesure pour la mesure de la position relative de deux objets, dans lequel une mesure matérialisée (M) présente une graduation (T) et, le long de cette graduation, dans la direction de mesure X, des repères de référence (Rn) associés de manière absolue à la graduation (T), dans lequel une unité de lecture (A) lit la graduation (T) pour produire au moins un signal de lecture (Sa, Sb) et les repères de référence (Rn) pour produire des signaux de référence (RSn) et dans lequel les valeurs absolues des repères de référence (Rn) sont définies en lisant la graduation (T) pour déterminer la distance (dn) entre des repères de références (Rn), caractérisé par le fait que l'on agence les distances (dn) mentionnées de manière telle que, pour déterminer la valeur absolue de chaque repère de référence (Rn) (n = 1, 2,3, ...), l'unité de lecture (A) Et au moins deux distances (dn-2, dn-1; dn-1, dn; dn, dn + 1) entre ces repères de référence (Rn) et au moins deux autres repères de référence (Rn-2, Rn-1; Rn-1, Rn + 1; Rn + 1, Rn + 2).

**2.** Procédé selon la revendication 1, caractérisé par le fait que des combinaisons identiques d'au moins deux distances (dn-2, dn-1; dn-1, dn; dn, dn + 1) successives dans la direction de mesure X positive et dans la direction de mesure X négative sont différenciées chaque fois par la direction de mesure X concernée.

**3.** Procédé selon la revendication 1, caractérisé par le fait que les combinaisons identiques d'au moins deux distances (dn-2, dn-1; dn-1, dn; dn, dn + 1) successives dans la direction de mesure X concernée ont une structure différente.

**4.** Procédé selon la revendication 1, caractérisé par le fait que les distances (dn) sont agencées sous forme de multiple entier de l'unité de graduation de longueur de période (P) de la graduation incrémentale (T).

**5.** Procédé selon la revendication 1, caractérisé par le fait que les repères de référence (Rn) sont disposés sur au moins deux pistes parallèles.

**6.** Procédé selon la revendication 1, caractérisé par le fait que les distances (dn-2, dn-1; dn-1, dn; dn, dn + 1) au nombre d'au moins deux sont définies dans un dispositif de détermination de valeur absolue (AB) au moyen d'une mémoire de position de compteur et d'un comparateur de position de compteur puis sont transmises à un dispositif d'association dans lequel, pour déterminer la valeur absolue de chaque repère de référence (Rn), les distances (dn-2, dn-1; dn-1, dn; dn, dn + 1) prédéterminées, au nombre d'au moins deux, sont préalablement enregistrées sous forme de tableau de distances.

Fig.1

Fig. 2

Fig. 3